# EUROPEAN PATENT SPECIFICATION

(11) **EP 1 214 174 B1**
(45) Date of publication and mention of the grant of the patent: **11.02.2004**
(21) Application number: 00954098.0
(22) Date of filing: 16.08.2000
(51) Int. Cl.: B24B 37/04, B24D 11/00, B24B 49/04, B24B 49/12

(54) **WINDOWLESS BELT AND METHOD FOR IN-SITU WAFER MONITORING**
FENSTERLOSES POLIERBAND UND VERFAHREN ZUM VOR-ORT ÜBERWACHEN EINER HALBLEITERSCHEIBE
COURROIE A OUVERTURE SANS FENETRE ET PROCEDE DE SURVEILLANCE DE TRANCHES IN SITU

(30) Priority: 31.08.1999 US 386745
(43) Date of publication of application: 19.06.2002
(73) Proprietor: LAM RESEARCH CORPORATION, Fremont, CA 94538 (US); SCAPA GROUP PLC, Blackburn, Lancashire BB2 6AY (GB)
(72) Inventor: XU, Cangshan, Fremont, CA 94538 (US); LOMBARDO, Brian, S., Amherst, NH 03031 (US); BAJAJ, Rajeev, Fremont, CA 94555 (US); SURANA, Rahul, K., Fremont, CA 94539 (US)
(74) Representative: Viering, Jentschura & Partner
(86) International application number: PCT/US2000/022429
(87) International publication number: WO 2001/015863

(56) References cited:
- EP-A- 0 893 203
- WO-A-99/06182

## Description

The present invention relates generally to equipment for processing wafers. More particularly, the present invention relates to a system and method for chemical mechanical polishing of semiconductor wafers.

Chemical mechanical polishing (CMP) is used for planarizing semiconductor wafers. Many steps in the manufacture of semiconductor devices produce a highly irregular surface on the wafer. In order to improve the manufacturability of semiconductors on the wafer, the wafer surface is planarized. For example, to improve the uniformity of deposition of a metal interconnect layer, the wafer is planarized to reduce the peaks and valleys on the surface.

In conventional planarization technology, a semiconductor wafer is supported face down against a moving polishing pad. Two types of polishing or planarizing apparatus are commonly used. In rotary planarizing technology, a wafer is secured on a chuck and brought into contact with a flat polishing pad mounted on a rotating table which forms the polishing surface. In linear planarizing technology, an endless belt travels over two or more rollers. The wafer is placed against the polishing surface of the belt. An example of such a system is the Teres^{TM} CMP System manufactured by Lam Research Corporation, Fremont, California.

Often it is desired for the surface of the wafer to be monitored during polishing. Typically, an optical window is provided on the belt. A beam of light is passed through the optical window. The beam of fight reflects off of the wafer through the window and the reflected light is measured.

The optical window prevents slurry from passing through the belt to the platen, where it could dry and foul or scratch the platen, block the optics or clog the fluid bearing holes. Some optical windows are designed to prevent pooling of the slurry on the window so that the light beam is not interfered with by the slurry. However, the optical window may alter or filter the beam of light. Inconsistencies in window material may lead to inconsistent monitoring of the surface of the wafer. For windows designed to flex towards the wafer when air pressure is applied, inconsistent window materials or thickness or positioning of the window in the belt may lead to inconsistent monitoring. Slurry pooting or build-up of dry slurry in the window may also cause inconsistent monitoring or scratching of the delicate and valuable wafers. Inconsistent monitoring may not allow for the maximum effectiveness of detecting the end point of planarization. In addition, in many cases, physical failure of the window ruins the belt which then needs to be replaced, regardless of the actual condition of the polishing surface of the belt.

WO 99 06182 A discloses a linear chemical mechanical polishing system comprising an endless belt having at least one aperture through the belt and free of a window.

EP-A-0 893 203 discloses a linear chemical mechanical polishing system comprising an endless belt having at least one aperture through the belt and free of a window, wherein a sensor enables measuring the surface state of a substrate being polished by a monitor.

Accordingly, there is a need in the art for an improved polishing belt for CMP systems that allows for more accurately and more reliably monitoring of a wafer surface, without allowing damage to the wafer or processing equipment.

According to the invention, this is achieved by a system and method according to the features of claims 1 and 10, respectively. Advantageous further embodiments are described in the subclaims.

By way of introduction only, an improved polishing belt for a chemical mechanical planarization (CMP) system is provided. The belt has an aperture through the belt so that the belt is free of a window. The light beam passes through the aperture unobstructed. Slurry is prevented from drying and cleared by applying water to the platen, or underside the belt. By using the aperture through the belt, more reliable monitoring is provided. The belt is also cheaper and simpler to manufacture which results in higher quality belts at lower cost. As a direct result of the absence of a window in the belt, less maintenance is needed, reducing belt failure or defects on delicate, valuable wafers.

The foregoing discussion of the preferred embodiments is provided only by way of introduction. Nothing in this section should be taken as a limitation on the following claims, which define the scope of the invention.
Figure 1 is a perspective view of a preferred embodiment of a linear chemical mechanical polishing system;
Figure 2 is a perspective view of a preferred embodiment a portion of a belt for use in the system of FIG. 1; and
Figure 3 is a flow diagram illustrating a preferred embodiment of a method for polishing a workpiece.

The preferred embodiments include a belt with an aperture through the belt so that the belt and aperture are free of a window. The aperture allows monitoring of the surface of a workpiece being polished without obstruction by an optical window. Forced air and/or water from a platen prevent the slurry from blocking fluid bearing holes in the platen and the optics and from otherwise fouling the platen surface.

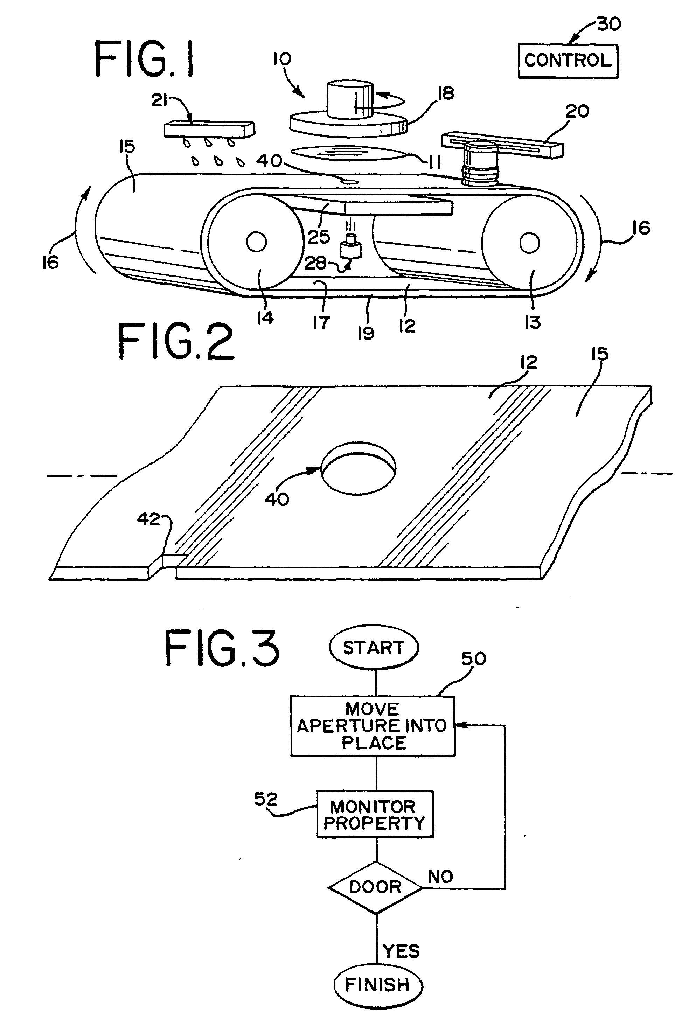

Figure 1 is a perspective view of a linear chemical mechanical polishing or planarization (CMP) system 10 for polishing a workpiece. The system 10 includes a belt 12, a first roller 14, a second roller 13, a platen 25, a polishing head 18, a slurry dispenser 21, a conditioner 20, a monitor 28 and a controller 30. The system 10 in the illustrated embodiment is adapted for planarization of workpieces, such as the semiconductor wafer 11. However, the operative principles embodied in the system 10 may be applied to chemical mechanical polishing of other workpieces as well.

The rollers 13, 14 are located a predetermined distance apart to tension and move the belt 12. The rollers 13, 14 are preferably between about 5,08 to 101,6 cm (2 to 40 inches) in diameter. Movement of the belt 12 linearly planarizes the wafer 11. One or both of the rollers 13, 14 are rotated, for example, by an electric motor in the direction indicated by the arrows 16. The rollers 13, 14 moye the belt past the wafer 11. Preferably, the belt 12 moves at a rate of about 3,048 to 304,8 m/min (10 to 1000 ft/minute) [most preferably about 30,48-121,9 m/min (100-400 ft/minute)]. Other transport means include combinations of wheels, pulleys and tensioning devices which maintain proper tension on the belt 12, along with associated drive elements such as electric motors and mechanical linkages.

Operational parameters such as the speed and tension of the belt 12 are controlled by the controller 30. The controller 30 comprises a processor or other computing device which operates in response to data and instructions stored in an associated memory.

In operation, the wafer 11 is mounted on the polishing head 18. The wafer 11 is mounted and retained in place by vacuum force, a retainer ring or by any other suitable technique. Preferably, a carrier film is used between the wafer 11 and the polishing head 18. The polishing head 18 is mounted on an arm and is movable under control of the controller 30. For example, the polishing head 18 rotates over the belt 12. The polishing head 18 applies a polishing pressure to the wafer 11 against the belt 12, such as a pressure of about 6,895-103,42 kPa (1-15 psi) [e.g. 34,47 KPa (5 psi)].

To further control the polishing pressure, the platen 25 is located opposite the polishing head 18 below the wafer 11. Preferably, the platen 25 comprises a fluid platen. In one embodiment, 1-250 ml per minute of water is provided at the center of the platen 25 and air pressure is provided in concentric rings radially outward from the center. The center, fluid portion of the preferred platen 25 comprises an area and shape corresponding to apertures 40 in the belt 12 as discussed below. Fluid platens are described in U.S. Patent Nos. 5,558,568 and 5,593,344. Other types of platens for controlling the polishing pressure may be used, such as mechanism's employing air pressure, water pressure, pressure from mechanical attachments, electromagnetic pressure or combinations thereof.

The belt 12 passes between the front surface of the wafer 11 and the platen 25. The platen 25 applies pressure to the belt 12. In some applications, the platen 25 is arranged to apply pressure in controllable zones or areas of the platen 25 under control of the controller 30. For example, 1-30 zones are arranged radially on the surface of the platen 25. This controlled application of pressure allows the belt 12 to polish uniformly across the surface of the wafer 11. Preferably, a pre-wet layer of de-ionized water mist is used between the belt 12 and the platen 25 to help prevent blockage of the flow channels by slurry.

The slurry dispenser 21 dispenses a slurry onto the belt 12, preferably at a flow rate of about 5-500 ml/minute. For uniform planarization or polishing, the slurry is distributed evenly across the surface of the wafer 11. Generally, the slurry includes two components. Different applications or materials use different components depending on the material to be removed or polished. For example, the slurry components for planarizing a silicon dioxide layer on the surface of the wafer 11 differ from the slurry components for planarizing a metal layer on the surface. Similarly, the slurry components appropriate for a tungsten metal layer are different from the components for a copper layer, which is softer than tungsten. In most cases, abrasive particles, such as silicon dioxide or alumina, are combined with a chemical, such as potassium hydroxide or NH₄OH for SiO₂ or H₂O, KIO₃ or Fe(NO₃)₃ for metal. However, chemical solutions containing no undissolved particles can be used. In these cases, abrasive particles may be incorporated in the polishing belt. The chemical softens or hydrates the surface, and the abrasive particles remove the surface material. In one embodiment, the slurry has a pH of about 1.5 to 12. One type of slurry is Klebesol available from Hoechst.

The conditioner 20 treats the surface of the belt 12 to keep the belt's roughness or abrasiveness relatively constant. As the belt 12 planarizes or polishes the wafer 11, the material removed from the wafer 11 deposits on the surface of the belt 12. The conditioner 20 cleans and roughens the surface of the belt 12 to remove deposits and prevent deformation of the belt 12.

The belt 12 is preferably an endless loop nolishing belt. In one embodiment, the belt 12 is 20,32-35,56 cm (8-14 inches) wide, 0,05-0,5 cm (0,020-0,200 inches) thick, about 228,6-279,4 cm (90-110 inches) long and held by the rollers 13, 14 at 2,224-22,24 kN (500-5000 pounds) of tension. In the illustrated embodiment, the belt 12 is sized for use with the Teres^{TM} CMP system available from Lam Research Corporation, Fremont, California.

The belt 12 has any suitable dimensions necessary for effective operation. Different polishing tools may require different belt lengths and widths. Different workpiece sizes may require different belt widths. Also, different types of polishing may require different properties: overall thicknesses, density, hardness, compressibility, elasticity and different relative thicknesses of multiple layers. Either the top or bottom surfaces of the belt 12 can be convex or concave or otherwise shaped to match the profile of the workpiece being polished or to match the rollers or supporting structures below the belt 12.

Various types of belts 12 may be used, such as (1) single or multi-layer belts, (2) belts reinforced with stainless steel, fibers or fabrics or (3) belts without such reinforcing, or (4) other known or yet to be developed belts such as belts made by adhering polishing pads to a supporting belt or band of stainless steel or other material with the desired properties. In one embodiment, the belt 12 is made with a single endless layer which provides both the surface for polishing and the mechanical strength for mounting, tensioning and tracking the belt without additional reinforcement. A polymeric layer, such as microcellular urethane, forms the endless loop. The polymeric material is of a substantially uniform thickness and structure. The belt 12 should be sufficiently elastic to maintain tension during use, i.e., not to relax and loosen during use. The belt 12 may be expected to operate at temperatures ranging from -60 to +150 °C.

In an alternative embodiment, the belt 12 has multiple layers. For example, a second layer can be combined with a polymeric polishing layer. The additional layers can be made of any suitable polymeric material including rubbers or plastics. Generally, the different layers are made of different materials and have different properties, structures, dimensions, and functions. In one example, a two-layer belt 12 has a top polishing layer as described below and a polymeric bottom or opposite layer. A softer underlayer beneath a harder polishing layer increases the overall rigidity of the belt 12 and allows enough softness so that the polishing layer flexes as to conform to the surface of the wafer 11.

The belt 12 has a polishing surface 15 on one side of the endless loop and an opposite or bottom surface 17 on the other side of the endless loop. The belt has edges 19 connecting the polishing surface 15 and the opposite surface 17. Typically, the outside or top surface of the belt 12 is the polishing surface 15, although the inside surface may be the polishing surface 15. In addition, the belt 12 may be reversible, and where both surfaces are used for polishing at the same or different times. The two surfaces may be used for different types of polishing operations, and multiple layer belts may comprise different materials tailored to different polishing applications.

In one embodiment, the polishing surface 15 of the belt 12 has a plurality of grooves. For example, the grooves are 0,127-2,54 mm (0.005 - 0.100 inch) deep with a width of 0,127-2,54 mm (.005 - .100 inch) and a pitch of 1-50 per 25,4mm (inch). Other groove parameters may be used, such as smaller grooves for transporting slurry under the wafer 11. The grooves are in any of various configurations, such as linear, rectangular, U or V shapes. The opposite surface 17 may be smooth or textured. The opposite surface 17 may have grooves or ridges or other physical features that allow the belt 12 to mate properly with the rollers 13, 14. The texturing and physical features on the surfaces of the belt 12 may be molded in or may be achieved in secondary manufacturing operations. In alternative embodiments, no grooves or textures are provided.

Other textures for the polishing surface 15 may be provided as an alternative to or in addition to grooves. The polishing layer can be solid or cellular. A solid layer is preferably uniformly solid throughout its length and cross section. Cellular polymers include voids or porosity which carries the slurry to the surface of the wafer 11. The cells may be open or closed and can be formed by any suitable means, including but not limited to blowing, expansion, frothing, and inclusion of hollow microelements. In one application, the polymeric material is a microcellular polyurethane having cells or voids on the order of 0.1 to 1000 micrometers in size. The polishing layer can include various additives, including but not limited to lubricants and abrasive particles.

To allow the use of a lower concentration of abrasive particles in the slurry, fillers and/or abrasive particles, such as with an average size less than 100 microns, may be dispersed throughout the polishing layer. A lower concentration in the slurry provides for less light scattering, providing for more accurate monitoring.

The polishing material can be made of any suitable material including rubbers or plastics. Examples of rubbers and plastics include but are not limited to, polyurethanes, polyureas, polyesters, polyethers, epoxies, polyamides, polycarbonates, polyethylenes, polypropylenes, fluoropolymers, vinyl polymers, acrylic and methacrylic polymers, silicones, latexes, nitrile rubbers, isoprene rubbers, butadiene rubbers, and various copolymers of styrene, butadiene, and acrylonitrile. The polymeric material can be thermoset or thermoplastic.

Referring to Figures 1 and 2, an aperture 40 is shown in the belt 12. The aperture 40 is through the belt 12, penetrating all layers of the belt 12. There is no obstruction, such as the prior art window formed or inserted in the belt 12. Thus, the belt 12 or aperture 40 is free of a window. By passing through the belt 12, the aperture 40 allows direct in-situ monitoring of the surface of the wafer 11. The aperture 40 is formed by punching or machining, such as laser cutting, the aperture 40 in the belt 12 or by forming the aperture 40 as part of the process of molding or forming the belt 12.

One or more apertures 40 may be provided through the belt 12. Preferably, three apertures 40 are evenly spaced apart along the length of the belt 12. The apertures are positioned in the center of the belt 12 between the edges 19. In one embodiment, each aperture is a 6,35-50,8 mm (0.25" - 2" inch) diameter circle shape. Preferably, the shape has few or no comers, such as elliptical or oval, to prevent trapping dried slurry. Shapes with comers may be used. Other shapes, sizes, placements and numbers of apertures 40 may be used.

The monitor 28 uses the aperture 40 to measure a property of the wafer 11. The monitor 28 comprises a light emitting and reception device for determining the type of film and/or film thickness of the surface of the wafer 11. For example, a short-distance diffuse reflex sensor, such as a Sunx model number CX-24 sensor, is used. A broad band beam comprising white light is emitted. Other wavelengths may be used, such as ultraviolet or infrared. Other monitors may be used. The term "monitor" is intended broadly to encompass any device that can be used for in-situ monitoring of a wafer during CMP processing. Such devices include, but are not limited to, a light source, interferometer, ellipsometer, beam profile refectometer, or optical stress generator. By measuring the property, the end point of the CMP process is determined. Removal rate, rate variation, and average removal rate may also be measured.

The monitor 28 is positioned adjacent the belt 12. Preferably, the monitor 28 is positioned below the platen 25. The monitor 28 directs a beam, such as a light beam, through a window in the platen 25, through the aperture 40 and onto the wafer 11. The beam is reflected back along the same path for measurement. In alternative embodiments, the monitor is positioned above or adjacent to the platen 25 or at other positions adjacent the belt 12.

In one embodiment, the monitor 28 is activated to measure when each aperture 40 is between the monitor 28 and the wafer 11. The monitor 28 is activated in response to a trigger mechanism. For example, a notch or trigger aperture 42 is provided along the edge 19 or at another portion of the belt 12. As the aperture 40 passes the monitor 28, the trigger aperture or notch 42 engages a sensor to indicate that the aperture 40 is adjacent the wafer 11. In response, the monitor 28 shines light or other energy on the belt 12 in the vicinity of the aperture 40., As the aperture 40 passes by the wafer 11, the monitor 28 measures the light or other energy reflected back from the wafer 11. By measuring the energy and its variation, the measuring system provides an indication of the polishing progress of the CMP system 10. The trigger aperture or notch 42 may be placed with any relation to the aperture 40. Further, a trigger aperture or notch 42 may be provided for each aperture 40 in the belt 12. In alternative embodiments, the monitor 28 is continuously active.

In addition to any notches 42, the edges 19 of the belt 12 are smooth, textured, or patterned. The edges 19 may contain holes or other physical features that serve other functional purposes, such as aiding in alignment and tracking of the belt in use or such as aiding in counting revolutions. The edges 19 of the belt 12 are formed during molding or created in a secondary manufacturing operation, such as cutting, drilling, lathing or punching.

In operation, the wafer 11 is positioned adjacent to the belt 12. The belt 12 polishes the wafer 11 as the rollers 13,14 rotate. The slurry dispenser 21 places slurry on the belt 12. Some of the slurry passes under the wafer 11. The wafer 11 moves some slurry to either side or edge of the belt 12. The conditioner 20 conditions the belt 12 after polishing. Using water, air or other pressure devices, the platen 25 applies pressure to the belt 12. The pressure ensures optimal pressure distributions and proper contact between the polishing surface 15 and the wafer 11.

Figure 3 shows a flow chart representing one embodiment of the CMP monitoring process. To monitor polishing, the apertures 40 pass between the wafer 11 and the monitor 28 in step 50. As one of the notches 42 passes a sensor, the monitor 28 is activated. The sensor is positioned so that the monitor 28 is triggered while the corresponding aperture 40 is between the monitor 28 and the wafer 11. Where more than one aperture 40 is provided, each aperture 40 passes along the wafer 11. The monitor 28 is triggered for each aperture 40. Upon activation, the monitor 40 directs a beam, such as a beam of light, at the wafer 11. Based on reflections, a property of the wafer 11 is detected in step 52.

To prevent dry slurry from blocking the optics or from scratching or clogging portions of the platen and fluid bearing holes, air and water are preferably used by the platen 25 to apply pressure to the belt 12. The water pre-wets the center of the platen 25. The water keeps the slurry from drying on the platen 25, from drying in the platen orifices where fluid (e.g. air or water) passes through to form the fluid bearing, and prevents scratches or film formation on the platen window. The pressure, whether water, air or pressure applied by other means, may keep the slurry from draining through the aperture 40 onto the monitor 28 or platen 25. The pressure may force some of the slurry onto the polishing surface 15 of the belt 12 adjacent to the wafer 11. In alternative embodiments, the dry slurry is prevented from falling through aperture 40. In yet other alternative embodiments, suction or gravity is used to pull slurry away from the aperture and prevent damaging or hindering performance of the platen. In yet other alternative embodiments, humidified air may be used to apply pressure to the underside of the belt 12 and to prevent slurry from drying or fouling the platen 25.

As can be seen from the foregoing, the present embodiments provide an improved chemical mechanical polishing belt and a method for using the belt. The belt does not require window materials. The obstruction free aperture through the belt allows for more reliable monitoring, reduced cost of manufacture, improved consistency for monitoring with different belts, easier maintenance, and reduced risk of failure. The monitoring beam is not filtered or reflected by any window where windows with different filtering and reflection properties are used on the same or different belts.

While a particular embodiment of the present invention has been shown and described, modifications may be made within the scope of the invention, as defined by the appended claims.

## Claims

1. A system (10) for polishing a workpiece (11) in a chemical mechanical polishing process, the system (10) comprising:
a monitor (28); and
an endless belt (12) positioned adjacent to the monitor (28), the endless belt (12) having at least one aperture (40) through the belt (12) wherein a path through the aperture (40) from the workpiece (11) to the monitor (28) is unobstructed, the aperture (40) being substantially free of a window,
wherein said endless belt (12) has a notch or trigger aperture (42) along a first edge of the belt (12), the notch or trigger aperture (42) being positioned relative to the aperture (40), wherein activation of the monitor (28) is responsive to a position of the notch or trigger aperture (42) relative to the workpiece (11) as determined by a sensor.

2. The system of claim 1 wherein the endless belt (12) has two substantially parallel edges (19) and the aperture (40) is centered between the two substantially parallel edges (19).

3. The system of claim 1 wherein the aperture (40) comprises a substantially circular shape.

4. The system of claim 1 wherein the endless belt (12) has at least three apertures (40).

5. The system of claim 4 wherein the at least three apertures (40) are evenly spaced around the endless loop.

6. The system of claim 1 further comprising a slurry dispenser (21) positioned adjacent to a polishing side of the endless belt (12).

7. The system of claim 6 further comprising a platen (25) adapted to apply water to the endless belt (12).

8. The system of claim 7 wherein the water is operable to prevent drying of the slurry and to substantially clear the platen (25) of slurry.

9. The system of claim 7 wherein the platen (25) is adapted to apply air to the endless belt (12).

10. A method for polishing a workpiece in a chemical mechanical polishing process, the method comprising the steps of:
(a) passing an endless belt (12) along a workpiece (11), the endless belt (12) having an aperture (40) through the belt (12), the aperture being free of a window;
(b) measuring a property of the workpiece (11) through the aperture, a path through the aperture for measuring the workpiece (11) being unobstructed by the aperture in the belt (12); and
(c) triggering step (b) in response to a position of a trigger notch or aperture (42) relative to the workpiece (11) as determined by a sensor.

11. The method of claim 10 wherein step (a) comprises passing a plurality of spaced apart apertures (40) along the workpiece (11).

12. The method of claim 10 wherein step (b) comprises directing a beam of light at the workpiece (11) through the aperture (40).

13. The method of claim 10 further comprising:
(d) applying slurry to a polishing side of the endless belt (12), a portion of the polishing side being adjacent to the workpiece (11).

14. The method of claim 13 further comprising:
(e) applying pressure to the endless belt (12) with water.

15. The method of claim 14 further comprising:
(f) preventing blockage by dry slurry in aperture (40) on a platen (25) with the water of step (e); and
(g) clearing slurry from the aperture (40) on the platen (25) with the water of step (e).

16. The method of claim 14 further comprising:
(f) applying pressure to the endless belt (12) with air.

## Patentansprüche

1. System (10) zum Polieren eines Werkstücks (11) in einem chemisch-mechanischen Polierprozess, wobei das System (10) aufweist:
einen Bildschirm (28); und
einen Endlosriemen (12), der benachbart zu dem Bildschirm (28) positioniert ist, wobei der Endlosriemen (12) wenigstens eine Öffnung (40) durch den Riemen (12) hindurch aufweist, wobei ein Pfad durch die Öffnung (40) hindurch von dem Werkstück (11) zu dem Bildschirm (28) ungehindert ist,
wobei die Öffnung (40) im Wesentlichen frei von einem Fenster ist,
wobei der Endlosriemen (12) eine Nut oder Triggeröffnung (42) entlang eines ersten Randes des Riemens (12) aufweist,
wobei die Nut oder Triggeröffnung (42) relativ zu der Öffnung (40) positioniert ist, wobei die Betätigung des Bildschirms (28) von einer Position der Nut oder Triggeröffnung (42) relativ zu dem Werkstück (11) abhängig ist, wie von einem Sensor bestimmt wird.

2. System nach Anspruch 1, wobei der Endlosriemen (12) zwei im Wesentlichen parallele Ränder (19) aufweist und die Öffnung (40) zwischen den beiden im Wesentlichen parallelen Rändern (19) zentriert ist.

3. System nach Anspruch 1, wobei die Öffnung (40) eine im Wesentlichen kreisförmige Form aufweist.

4. System nach Anspruch 1, wobei der Endlosriemen (12) wenigstens drei Öffnungen (40) aufweist.

5. System nach Anspruch 4, wobei die wenigstens drei Öffnungen (40) um die Endlosschleife herum im gleichmäßigen Abstand voneinander angeordnet sind.

6. System nach Anspruch 1, ferner aufweisend einen Aufschlämmungsspender (21), der benachbart zu einer Polierseite des Endlosriemens (12) positioniert ist.

7. System nach Anspruch 6, ferner aufweisend eine Platte (25), die angepasst ist, um Wasser auf den Endlosriemen (12) aufzubringen.

8. System nach Anspruch 7, wobei das Wasser wirksam ist, um das Austrocknen der Aufschlämmung zu verhindern und die Platte (25) von Aufschlämmung im Wesentlichen zu klären.

9. System nach Anspruch 7, wobei die Platte (25) angepasst ist, um Luft auf den Endlosriemen (12) aufzubringen.

10. Verfahren zum Polieren eines Werkstücks in einem chemisch-mechanischen Polierprozess, wobei das Verfahren die Schritte aufweist:
(a) Passieren eines Endlosriemens (12) entlang eines Werkstücks (11), wobei der Endlosriemen (12) eine Öffnung (40) durch den Riemen (12) hindurch aufweist, wobei die Öffnung frei von einem Fenster ist;
(b) Messen einer Eigenschaft des Werkstücks (11) durch die Öffnung hindurch, wobei ein Pfad durch die Öffnung zum Messen des Werkstücks (11) hindurch von der Öffnung in dem Riemen (12) ungehindert ist; und
(c) Auslösen des Schritts (b) in Erwiderung auf eine Position einer Triggernut oder Öffnung (42) relativ zu dem Werkstück (11), wie von einem Sensor bestimmt wird.

11. Verfahren nach Anspruch 10, wobei der Schritt (a) Passieren einer Mehrzahl von im Abstand voneinander angeordneten Öffnungen (40) entlang des Werkstücks (11) aufweist.

12. Verfahren nach Anspruch 10, wobei der Schritt (b) Ausrichten eines Lichtstrahls auf das Werkstück (11) durch die Öffnung (40) hindurch aufweist.

13. Verfahren nach Anspruch 10, ferner aufweisend:
(d) Aufbringen von Aufschlämmung auf eine Polierseite des Endlosriemens (12), wobei ein Abschnitt der Polierseite benachbart zu dem Werkstück (11) ist.

14. Verfahren nach Anspruch 13, ferner aufweisend:
(e) Aufbringen von Druck auf den Endlosriemen (12) mit Wasser.

15. Verfahren nach Anspruch 14, ferner aufweisend:
(f) Verhindern von Blockierung durch trockene Aufschlämmung in der Öffnung (40) an einer Platte (25) mit dem Wasser aus Schritt (e); und
(g) Klären von Aufschlämmung aus der Öffnung (40) an der Platte (25) mit dem Wasser aus Schritt (e).

16. Verfahren nach Anspruch 14, ferner aufweisend:
(f) Aufbringen von Druck auf den Endlosriemen (12) mit Luft.

## Revendications

1. Système (10) de polissage de pièce (11) utilisé dans un procédé de polissage chimique et mécanique, le système (10) comprenant :
un dispositif de surveillance (28) ; et
une courroie sans fin (12) positionnée de manière adjacente au dispositif de surveillance (28), la courroie sans fin (12) ayant au moins une ouverture (40) à travers la courroie (12) dans laquelle une trajectoire entre la pièce (11) et le dispositif de surveillance (28) à travers l'ouverture (40) n'est pas obstruée, l'ouverture (40) étant sensiblement exempte de fenêtre,
dans lequel ladite courroie sans fin (12) a une ouverture (42) à encoche ou à déclenchement le long d'un premier bord de la courroie (12), l'ouverture (42) à encoche ou à déclenchement étant positionnée par rapport à l'ouverture (40), et où l'actionnement du dispositif de surveillance se fait en réponse à une certaine position de l'ouverture (42) à encoche ou à déclenchement par rapport à la pièce (11) qui est déterminée par un capteur.

2. Système selon la revendication 1, dans lequel la courroie sans fin (12) a deux bords sensiblement parallèles (19) et où l'ouverture (40) est centrée entre les deux bords sensiblement parallèles (19).

3. Système selon la revendication 1, dans lequel l'ouverture (40) comporte une forme sensiblement circulaire.

4. Système selon la revendication 1, dans lequel la courroie sans fin (12) a au moins trois ouvertures (40).

5. Système selon la revendication 4, dans lequel les au moins trois ouvertures (40) sont régulièrement espacées autour de la boucle sans fin.

6. Système selon la revendication 1, comprenant en outre un distributeur de boue liquide (21) positionné de manière adjacente à un côté de polissage de la courroie sans fin (12).

7. Système selon la revendication 6, comprenant en outre un plateau (25) prévu pour appliquer de l'eau sur la courroie sans fin (12).

8. Système selon la revendication 7, dans lequel l'eau permet d'empêcher que la boue liquide sèche et de dégager sensiblement la boue liquide du plateau (25).

9. Système selon la revendication 7, dans lequel le plateau (25) est prévu pour appliquer de l'air sur la courroie sans fin (12).

10. Procédé de polissage de pièce utilisé pour le polissage chimique et mécanique, le procédé comprenant les étapes consistant à :
(a) faire passer une courroie sans fin (12) le long d'une pièce (11), la courroie sans fin (12) ayant une ouverture (40) à travers la courroie (12), l'ouverture étant exempte de fenêtre ;
(b) mesurer une caractéristique de la pièce (11) à travers l'ouverture, une trajectoire à travers l'ouverture destinée à mesurer la pièce (11) n'étant pas obstruée par l'ouverture pratiquée dans la courroie (12) ; et
(c) déclencher l'étape (b) en réponse à la détection par un capteur d'une certaine position d'une ouverture à encoche ou à déclenchement (42) par rapport à la pièce (11).

11. Procédé selon la revendication 10, dans lequel l'étape (a) consiste à faire passer le long de la pièce (11) une pluralité d'ouvertures (40) espacées les unes des autres.

12. Procédé selon la revendication 10, dans lequel l'étape (b) consiste à diriger un faisceau de lumière sur la pièce (11) à travers l'ouverture (40).

13. Procédé selon la revendication 10, comprenant en outre l'étape consistant à :
(d) appliquer la boue liquide à un côté de polissage de la courroie sans fin (12), une partie du côté de polissage étant adjacente à la pièce (11).

14. Procédé selon la revendication 13, comprenant en outre l'étape consistant à :
(e) exercer une pression sur la courroie sans fin (12) avec de l'eau.

15. Procédé selon la revendication 14, comprenant en outre l'étape consistant à :
(f) empêcher avec l'eau mentionnée à l'étape (e) l'obstruction par de la boue séchée de l'ouverture (40) sur un plateau (25) ; et
(g) nettoyer la boue liquide de l'ouverture (40) sur le plateau (25) avec l'eau mentionnée à l'étape (e).

16. Procédé selon la revendication 14 comprenant en outre l'étape consistant à :
(f) exercer une pression sur la courroie sans fin (12) avec de l'air.
